# EUROPÄISCHE PATENTSCHRIFT

(11) **EP 2 230 683 B1**
(45) Veröffentlichungstag und Bekanntmachung des Hinweises auf die Patenterteilung: **16.03.2016**
(21) Anmeldenummer: 09003874.6
(22) Anmeldetag: 18.03.2009
(51) Int. Cl.: H01L 21/67, B32B 43/00

(54) **Vorrichtung und Verfahren zum Ablösen eines Wafers von einem Träger**
Device and method for releasing a wafer from a holder
Dispositif et procédé de séparation d'une tranche de silicium à partir d'un support

(43) Veröffentlichungstag der Anmeldung: 22.09.2010
(60) Teilanmeldung: 11182804.2
(73) Patentinhaber: EV Group GmbH, 4782 St. Florian (AT)
(72) Erfinder: Thallner, Erich, 4782 St. Florian (AT)
(74) Vertreter: Schweiger, Johannes

(56) Entgegenhaltungen:
- DE-A1- 10 108 369
- DE-A1-102006 000 687
- US-A- 5 688 411
- US-A- 5 800 665
- US-A1- 2002 106 869
- US-A1- 2002 132 447

## Beschreibung

Die Erfindung betrifft eine Vorrichtung gemäß Anspruch 1 und ein Verfahren gemäß Anspruch 12 zum Ablösen eines Wafers von einem Träger.

Das Rückdünnen von Wafern ist in der Halbleiterindustrie häufig erforderlich und kann mechanisch und/oder chemisch erfolgen. Zum Rückdünnen werden die Wafer in der Regel auf einen Träger vorübergehend fixiert, wobei es für die Fixierung verschiedene Methoden gibt. Als Trägermaterial werden beispielsweise Folien, Glassubstrate oder Siliziumwafer verwendet.

In Abhängigkeit von den verwendeten Trägermaterialien und der verwendeten Verbindungsschicht zwischen Träger und Wafer sind verschiedene Verfahren zur Auflösung oder Zerstörung der Verbindungsschicht bekannt, wie beispielsweise die Verwendung von UV-Licht, Laserstrahlen, Temperatureinwirkung oder Lösungsmittel.

Die US 2002/0106869 A1 betrifft eine Trennvorrichtung für gedünnte Halbleitersubstrate mit einer mechanischen Trennung der Verbindungsschicht. Die US 5,688,411 betrifft ein Verfahren und eine Vorrichtung, mit der eine Beschichtung von einer Kante eines Substrats entfernt werden kann. Die US 5,800,665 betrifft eine Vorrichtung und ein Verfahren zur Herstellung von Halbleitern in einem Tauchbad.

Das Ablösen stellt sich zunehmend als einer der kritischsten Prozessschritte dar, da die dünnen Substrate mit Substratdicken von wenigen µm beim Ablösen/Abziehen leicht brechen oder durch die für den Vorgang des Ablösens notwendigen Kräfte Schaden erleiden.

Darüber hinaus haben die dünnen Substrate kaum bis keine Formstabilität und rollen sich typischerweise ohne Stützmaterial ein. Während der Handhabung der rückgedünnten Wafer ist mithin eine Fixierung und Unterstützung der Wafer praktisch unumgänglich.

Die DE 10 2006 032 488 B4 beschreibt ein Verfahren zum Erhitzen des Verbindungsstoffs mittels Laserlicht, wobei die Verbindungswirkung des Verbindungsstoffs durch die damit verbundene erhebliche Temperaturerhöhung auf 400 bis 500°C aufgehoben wird. Damit wird zwar das Problem des Erhitzens des gesamten Wafer-Stapels (siehe dort: [0021]) gelöst. Zumindest der Randbereich und wegen der guten thermischen Leitung des Wafermaterials auch der zum Randbereich benachbarte Bereich wird aber einer erheblichen Temperaturerhöhung unterzogen. Problematisch ist dabei auch der entstehende Temperaturgradient.

Es ist daher die Aufgabe der vorliegenden Erfindung, eine Vorrichtung und ein Verfahren anzugeben, um einen Wafer möglichst zerstörungsfrei von einem Träger zu lösen.

Diese Aufgabe wird mit den Merkmalen der Ansprüche 1 und 12 gelöst. Vorteilhafte Weiterbildungen der Erfindung sind in den Unteransprüchen angegeben.

Der Erfindung liegt der Gedanke zugrunde, eine Vorrichtung anzugeben, mit der das Ablösen bei einer Temperatur kleiner als 350°C ermöglicht wird. Es hat sich herausgestellt, dass gerade die über 350°C liegenden Temperaturbereiche für den Wafer schädlich sein können. Für höhere Temperaturen wird außerdem mehr Energie benötigt, so dass die erfindungsgemäße Vorrichtung weniger Energie benötigt, um den Wafer vom Träger zu lösen.

Demnach kann die erfindungsgemäße Vorrichtung zum Ablösen eines Wafers von einem mit dem Wafer durch eine Verbindungsschicht verbundenen Träger durch folgende Merkmale gekennzeichnet sein:
- einer Aufnahmeeinrichtung zur Aufnahme eines aus dem Träger und dem Wafer bestehenden Träger-Wafer-Verbundes,
- einem Verbindungslösemittel zur Lösung der durch die Verbindungsschicht vorgesehenen Verbindung zwischen Träger und Wafer und
- Ablösungsmitteln zur Ablösung des Wafers von dem Träger oder zur Ablösung des Trägers von dem Wafer,
wobei das Verbindungslösemittel in einem Temperaturbereich von 0 bis 350°C, insbesondere von 10 bis 200°C, vorzugsweise von 20 bis 80°C, noch bevorzugter bei Umgebungstemperatur arbeitend ausgebildet ist.

Weiterhin ist erfindungsgemäß ein Verfahren zum Ablösen eines Wafers von einem mit dem Wafer durch eine Verbindungsschicht verbundenen Träger vorgesehen, das nachfolgende Schritte aufweisen kann:
- Aufnahme eines aus dem Träger und dem Wafer bestehenden Träger-Wafer-Verbundes auf einer Aufnahmeeinrichtung,
- Lösung der durch die Verbindungsschicht vorgesehenen Verbindung zwischen Träger und Wafer durch ein Verbindungslösemittel und
- Ablösung des Wafers von dem Träger oder zur Ablösung des Trägers von dem Wafer durch Ablösungsmitteln,
wobei das Verbindungslösemittel in einem Temperaturbereich von bis 350°C, insbesondere von 10 bis 200°C, vorzugsweise von 20 bis 80°C, noch bevorzugter bei Umgebungstemperatur arbeitet.

Mit Wafer ist ein Produktsubstrat, beispielsweise ein Halbleiterwafer gemeint, das üblicherweise auf eine Dicke zwischen 0,5 µm und 250 µm gedünnt ist, wobei die Tendenz zu immer dünneren Produktsubstraten geht.

Als Träger wird beispielsweise ein Trägersubstrat mit einer Dicke zwischen 50 µm und 5.000 µm verwendet.

Als Verbindungsschicht kommt ein Kleber, beispielsweise ein lösbarer Kleber, insbesondere ein Thermoplast in Frage, der beispielsweise selektiv in einem Randbereich des Träger-Wafer-Verbundes, insbesondere in einer Randzone von 0,1 bis 20 mm, aufgebracht wird. Alternativ kann der Kleber vollflächig aufgebracht werden, wobei die Klebekraft im Zentrum durch eine haftreduzierende Schicht, beispielsweise ein Fluorpolymer, vorzugsweise Teflon, reduziert sein kann.

Als Aufnahmeeinrichtung eignet sich besonders ein Chuck, insbesondere ein Spinner Chuck zur Aufnahme des Träger-Wafer-Verbundes, insbesondere mittels Unterdruck, beispielsweise Saugbahnen, Bohrungen oder Saugnäpfen. Alternativ ist eine mechanische Aufnahme, beispielsweise durch seitliche Klammern, denkbar.

Als Ablösungsmittel kann eine obere Substrataufnahme, beispielsweise ein Release-chuck, dienen, vorzugsweise durch Unterdruckbeaufschlagung, beispielsweise Saugbahnen, Bohrungen oder Saugnäpfe.

In einer vorteilhaften Ausführungsform der Erfindung ist vorgesehen, dass das Verbindungslösemittel im Wesentlichen erhitzungsfrei arbeitend ausgebildet ist. Auf diese Weise ist es möglich, auf jegliche Heizeinrichtung zu verzichten.

In einer weiteren vorteilhaften Ausführungsform der Erfindung ist vorgesehen, dass das Verbindungslösemittel Fluidmittel, insbesondere ein die Verbindungsschicht selektiv auflösendes Lösungsmittel, zur Lösung der Verbindungssicht umfasst. Die chemische Auflösung der Verbindungssicht ist für den Wafer besonders schonend und bei entsprechender Materialwahl kann die Auflösung auch sehr schnell erfolgen, insbesondere wenn nur Randbereiche des Wafers mit einer Verbindungsschicht versehen sind, so dass das Lösungsmittel von der Seite her schnell wirken kann. Auf diese Weise kann auf Perforierungen im Trägersubstrat und/oder Produktsubstrat verzichtet werden.

In einer alternativen Ausführungsform der Erfindung ist vorgesehen, dass das Verbindungslösemittel mechanische Trennmittel, insbesondere eine Klinge zum Durchschneiden der Verbindungsschicht, zur Lösung der Verbindungsschicht umfasst. Hierdurch ist eine besonders schnelle Trennung des Wafers vom Träger möglich. Denkbar ist auch eine Kombination aus mechanischen Trennmitteln und Fluidmitteln.

In einer weiteren alternativen Ausführungsform der Erfindung ist vorgesehen, dass das Verbindungslösemittel eine UV-Lichtquelle zur Lösung der Verbindungssicht umfasst. Auch diese Ausführungsform ist mit der Ausführungsform der mechanischen Trennmittel und/oder der Ausführungsform mit Fluidmitteln kombinierbar.

Soweit das Verbindungslösemittel, insbesondere ausschließlich, von einem Seitenrand des Träger-Wafer-Verbundes wirkend ausgebildet ist, kann auf eine Einwirkung des Wafers und/oder Trägers von der Oberseite und/oder der Unterseite, insbesondere einem innerhalb des Seitenrandes liegenden Innenbereich des Wafers, verzichtet werden.

Indem eine Rotationseinrichtung zur Rotation des Träger-Wafer-Verbundes vorgesehen ist, kann auf eine Anordnung der Verbindungslösemittel über den gesamten Umfang des Träger-Wafer-Verbundes verzichtet werden und eine teilweise Beaufschlagung am Umfang des Träger-Wafer-Verbundes ist ausreichend.

Mit Vorteil weist das Verbindungslösemittel mindestens eine den Seitenrand umgreifende, insbesondere an der Aufnahmeeinrichtung und/oder den Ablösungsmitteln, vorzugsweise dichtend, angeschlagene, Löseeinrichtung auf. Indem die Löseeinrichtung den Seitenrand des Träger-Wafer-Verbundes umgreift, ist eine besonders effektive Einwirkung auf die Verbindungsschicht möglich. Darüber hinaus dient die Löseeinrichtung dem Schutz des Wafers, insbesondere dem Schutz des Seitenrandes. Weiterhin kann durch die Maßnahme des Umgreifens verhindert werden, dass Fluidmittel aus der Löseeinrichtung austreten oder UV-Licht-Intensität verloren geht. Beim Einsatz von mechanischen Trennmitteln wird vermieden, dass etwaige Verunreinigungen aus der Löseeinrichtung austreten und den Wafer verunreinigen. Die Löseeinrichtung kann in vorteilhafter Ausgestaltung im Querschnitt U-förmig ausgebildet sein.

Soweit das Verbindungslösemittel, insbesondere die Löseeinrichtung, eine, vorzugsweise zur Umgebung abgedichtete, Arbeitskammer aufweist, werden die oben genannten Vorteile noch besser umgesetzt, insbesondere bei Verwendung von Fluidmitteln.

In einer weiteren vorteilhaften Ausgestaltung der Erfindung ist vorgesehen, dass die Arbeitskammer einen Umfangssektor des Seitenrandes des Träger-Wafer-Verbundes aufnehmend ausgebildet ist. Mit Vorteil reicht die Arbeitskammer nur geringfügig über den Seitenrand des Träger-Wafer-Verbundes in Richtung des Waferzentrums hinein, insbesondere bis zu der Aufnahmerichtung auf der Trägerseite und bis zu den Ablösungsmitteln auf der Waferseite.

Erfindungsgemäß sind die Ablösungsmittel rotierbar ausgebildet, insbesondere mittels der rotierbaren Aufnahmeeinrichtung angetrieben.

Soweit das Verbindungslösemittel Reinigungsmittel zur Reinigung des Wafers aufweist, kann gleichzeitig mit dem Ablösen des Wafers eine Reinigung des Wafers zumindest in dem mit Verbindungsschicht beaufschlagten Bereich erfolgen.

Das erfindungsgemäße Verfahren wird dadurch verbessert, dass die Verbindungsschicht im Bereich eines Seitenrandes des Träger-Wafer-Verbundes haftend und in einem, insbesondere aus einem Fluorpolymer gebildeten, vorzugsweise ausschließlich den Wafer kontaktierenden, Innenbereich zumindest in Richtung des Wafers weniger bis nicht haftend ausgebildet ist.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: Eine schematische Darstellung der erfindungsgemäßen Vorrichtung in einem ersten erfindungsgemäßen Verfahrensschritt,
- Figur 2:: eine schematische Darstellung der erfindungsgemäßen Vorrichtung in einem zweiten erfindungsgemäßen Verfahrensschritt,
- Figur 3a, 3b, 3c:: eine schematische Detailansicht der erfindungsgemäßen Löseeinrichtung in einem zweiten erfindungsgemäßen Verfahrensschritt,
- Figur 4:: eine schematische Detailansicht der erfindungsgemäßen Löseeinrichtung in einem erfindungsgemäßen dritten Verfahrensschritt,
- Figur 5:: eine schematische Darstellung der erfindungsgemäßen Vorrichtung in einem Reinigungsschritt zur Reinigung eines erfindungsgemäßen Trägers und
- Figur 6:: eine schematische Darstellung der erfindungsgemäßen Vorrichtung in einer alternativen Ausführungsform.

In den Figuren sind gleiche Bauteile und Bauteile mit der gleichen Funktion mit den gleichen Bezugszeichen gekennzeichnet.

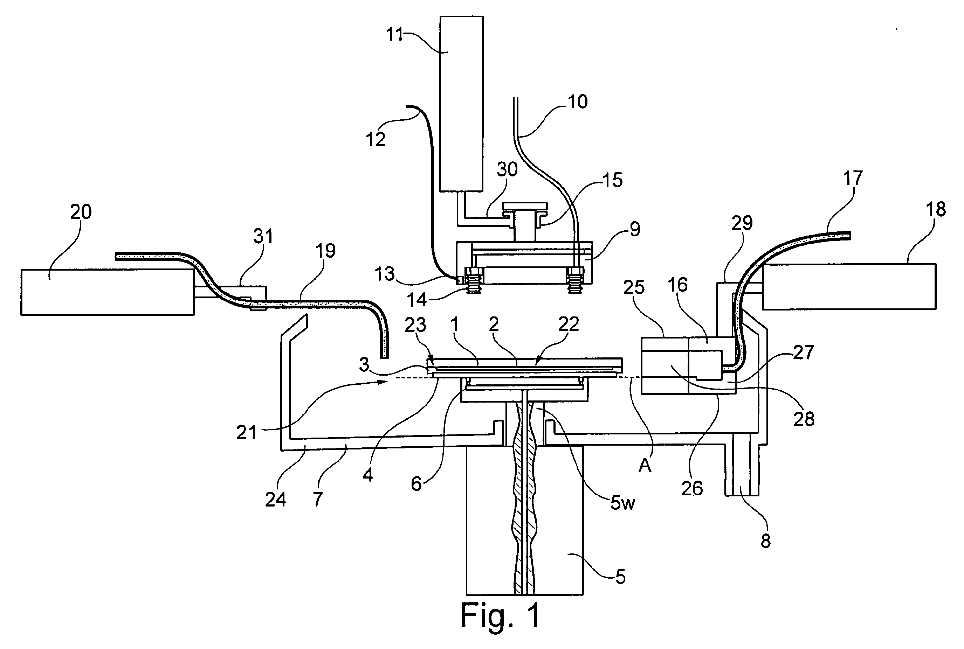

In Figur 1 ist in etwa mittig ein zumindest aus einem Wafer 4 und einem Träger 1 bestehenden Träger-Wafer-Verbund 21 dargestellt, der auf einer Aufnahmeeinrichtung 6, insbesondere einem Chuck, aufgenommen ist, und zwar in einer durch die Aufnahmeeinrichtung gebildeten, horizontalen Aufnahmeebene A. Der Träger-Wafer-Verbund 21 kann auch um 180° C gedreht auf der Aufnahmeeinrichtung 6 platziert werden, d.h. mit dem Träger 1 nach unten und dem Wafer 4 nach oben. Die Zuführung des Träger-Wafer-Verbundes 21 erfolgt über einen nicht dargestellten Roboterarm.

Gemäß einer besonders vorteilhaften Ausführungsform ist die Aufnahmeeinrichtung 6 beziehungsweise die Vorrichtung gegenüber der Horizontalen gezeigt, so dass die Aufnahmeebene A nicht mehr horizontal angeordnet ist, sondern einen Neigungswinkel zur Horizontalen aufweist, der zwischen 5° und 90° insbesondere 25° bis 90°, vorzugsweise 45° bis 90°, noch bevorzugter genau 90° beträgt.

Der Träger-Wafer-Verbund 21 besteht vorliegend weiter aus einer Verbindungsschicht 3 sowie einer in die Verbindungsschicht 3 integrierten haftreduzierenden Schicht 2, die in Richtung des Trägers 1 in einem Innenbereich 22 des Träger-Wafer-Verbundes 21 angeordnet ist. Außerhalb des Innenbereichs 22 wird die haftreduzierende Schicht 2 von der Verbindungsschicht 3 an einem Seitenrand 23 des Träger-Wafer-Verbundes 21 überragt. Der Seitenrand 23 ist damit ein ringförmiger Abschnitt und dieser erstreckt sich von der Außenkontur des Träger-Wafer-Verbunds 21 beziehungsweise des Trägers 1 zum Zentrum des Träger-Wafer-Verbundes 21, und zwar in einer Breite von 0,1 mm bis 20 mm. Der Wafer 4 hat typischerweise einen Durchmesser von 300 mm.

Der Wafer 4 ist vor dem Zuführen zur erfindungsgemäßen Vorrichtung üblicherweise weiteren Behandlungsschritten unterzogen worden, beispielsweise einem Rückdünnen auf eine Dicke von 0,5 µm bis 250 µm.

Der Träger-Wafer-Verbund 21 überragt die Aufnahmeeinrichtung 6 zumindest um den Seitenrand 23. Die Aufnahmeeinrichtung 6 weist demnach einen geringeren Durchmesser als der Träger-Wafer-Verbund 21 beziehungsweise der Wafer 4 und/oder der Träger 1 auf.

Der Träger-Wafer-Verbund 21 wird mittels Unterdruck auf bekannte Art und Weise auf der Aufnahmeeinrichtung 6 fixiert, wobei die Aufnahmeeinrichtung 6 über einen Antriebsmotor 5 und eine die Aufnahmeeinrichtung 6 mit dem Antriebsmotor 5 verbindende Antriebswelle 5w rotierbar ist.

Der Antriebsmotor 5 und die Antriebswelle 5w können als Hohlwelle mit einer Vakuumversorgung ausgestaltet sein, um die Vakuumversorgung an der rotierbaren Aufnahmeeinrichtung 6 in vorteilhafter Weise anschließen zu können.

Der Träger-Wafer-Verbund 21 ist in einer Prozesskammer 7 untergebracht, wobei der Antriebsmotor 5 außerhalb der Prozesskammer 7 angeordnet ist und die Antriebswelle 5w eine im Boden 24 der Prozesskammer angeordnete Öffnung durchsetzend ausgebildet ist.

Im Boden 24 ist weiterhin ein Ablauf 8 vorgesehen.

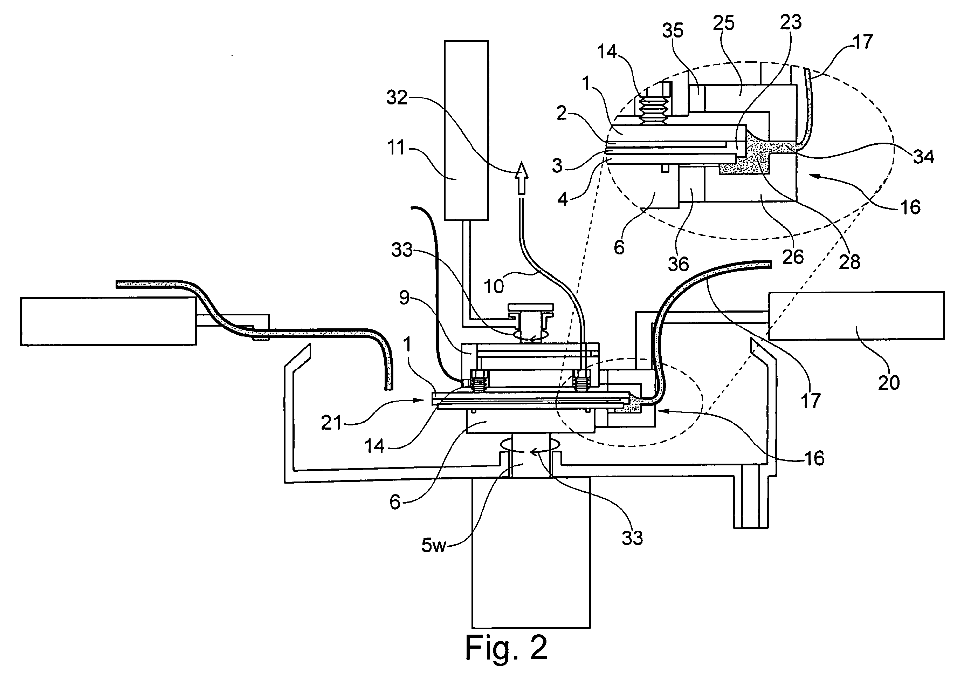

Seitlich von dem Träger-Wafer-Verbund 21 ist eine Löseeinrichtung 16 vorgesehen, die sich über einen Teil des Umfangs des Träger-Wafer-Verbundes 21 erstreckt. Die Löseinrichtung 16 ist im Querschnitt U-förmig ausgebildet und Schenkel 25, 26 der Löseeinrichtung sowie eine Seitenwand 27 der Löseeinrichtung 16 umschließen eine Arbeitskammer 28, die zum Träger-Wafer-Verbund 21 hin offen ausgebildet ist. Die Löseeinrichtung erstreckt sich über ein Kreisringsegment des Träger-Wafer-Verbundes 21 und die Schenkel 25, 26 überragen den Seitenrand 23 in einer in Figur 2 dargestellten Löseposition, die dem zweiten Verfahrensschritt des erfindungsgemäßen Verfahrens entspricht. Soweit die Aufnahmeebene A geneigt ist, kann die Löseeinrichtung wie ein Tauchbad ausgebildet sein, was eine Handhabung der Vorrichtung extrem vereinfacht.

Die Löseeinrichtung 16 ist über einen in die Prozesskammer 7 ragenden, L-förmigen Aktuatorarm 29 mittels eines Aktuators 18 von der Löseposition in eine Ausgangsposition gemäß Figur 1 verfahrbar.

Oberhalb des Träger-Wafer-Verbundes 21 sind Ablösungsmittel zur Ablösung des Trägers 1 von dem Wafer 4 vorgesehen, wobei die Ablösungsmittel eine Waferaufnahme 9, hier ein Chuck, aufweisen.

Die Waferaufnahme 9 ist an einem Waferaufnahmeaktuatorarm 30 rotierbar in einer Waferaufnahmelagerung 15 des Waferaufnahmeaktuatorarms 30 gelagert, wobei die Waferaufnahmelagerung 15 als Axial- und Radial-Lager ausgebildet ist. Die Waferaufnahmelagerung 15 sowie die Waferaufnahme 9 sind mit ihrer Rotationsachse fluchtend zu der Rotationsachse der Antriebswelle 5w beziehungsweise der Aufnahmeeinrichtung 6 angeordnet.

Die Ablösemittel weisen weiterhin in die Waferaufnahme 9 integrierte, federnde Saugnäpfe 14 auf, die hier als Balg ausgebildet sind. Die Saugnäpfe 14 sind an eine Druckleitung 10 angeschlossen, die wiederum mit einer Vakuumeinrichtung verbunden ist. Damit kann der Träger 1 im Bereich der Saugnäpfe 14 an die Waferaufnahme 9 angesaugt werden.

Weiterhin weist die erfindungsgemäße Vorrichtung gemäß Figur 1 eine über einen Lösungsmittelaktuatorarm 31 mit einem Lösungsmittelaktuator 20 verbundene Lösungsmittelleitung 19 zur Reinigung des Wafers 4 nach Ablösen des Trägers 1 von dem Wafer 4 auf.

Mit einem zur Distanzmessung vorgesehenen Sensor 13, der in die Waferaufnahme 9 integriert ist, ist die Ablösung des Trägers 1 von dem Wafer 4 messbar, und zwar über eine Sensorleitung 12.

Nach der Aufnahme des Träger-Wafer-Verbundes 21 gemäß Figur 1 wird die Waferaufnahme 9 durch den Waferaufnahmeaktuator 11 auf den Träger 1 abgesenkt, bis die Saugnäpfe 14 auf dem Träger 1 aufliegen.

Anschließend wird über die Druckleitung 10 Vakuum an die Saugnäpfe 14 angelegt, was durch einen Pfeil 32 dargestellt ist.

Damit ist die Waferaufnahme 9 mechanisch mit dem Träger-Wafer-Verbund 21 sowie der Aufnahmeeinrichtung 6 verbunden, so dass durch den Antriebsmotor 5 eine Rotation der Aufnahmeeinrichtung 6, der Waferaufnahme 9 und des dazwischen befindlichen Träger-Wafer-Verbundes 21 bewirkt werden kann. Die Rotation ist durch Rotationspfeile 33 dargestellt. Alternativ kann die Rotation diskontinuierlich, insbesondere durch wechselseitige Schwenkbewegung mit begrenztem Winkel zwischen 90° und 360° erfolgen, wobei durch die Schwenkbewegung der Umfang des Träger-Wafer-Verbundes 21 von der Löseeinrichtung 16 quasi-vollständig erfassbar sein soll.

Bei kontinuierlicher Rotation kann für die Druckleitung 10 und die Sensorleitung 12 mit Vorteil eine Rotationswelle zur Zuführung zur Waferaufnahme 9 vorgesehen sein.

Anschließend wird die Löseeinrichtung 16 durch den Löseeinrichtungsaktuator 20 in die in Figur 2 dargestellte Löseposition herangefahren, die auch in einem in Figur 2 oben rechts angeordneten Vergrößerungsausschnitt dargestellt ist.

Anschließend wird über die Fluidleitung 17 Lösungsmittel 34 in die Arbeitskammer 28 der Löseeinrichtung 16 eingeleitet, wo das Lösungsmittel 34 mit der Verbindungsschicht 3 im Bereich des Seitenrandes 23 in Kontakt tritt und zu einer Auflösung der Verbindungsschicht 3 von der Seite her führt.

Die Arbeitskammer 28 kann durch Anschlag der Löseeinrichtung 16, insbesondere der Schenkel 25 und 26 mit deren Stirnflächen 35 und 36 an die Aufnahmeeinrichtung 6 beziehungsweise die Waferaufnahme 9 zur Umgebung abgedichtet sein.

Eine Abdichtung ist dagegen nicht zwingend erforderlich, führt aber zu einer Einsparung von Lösungsmittel 34.

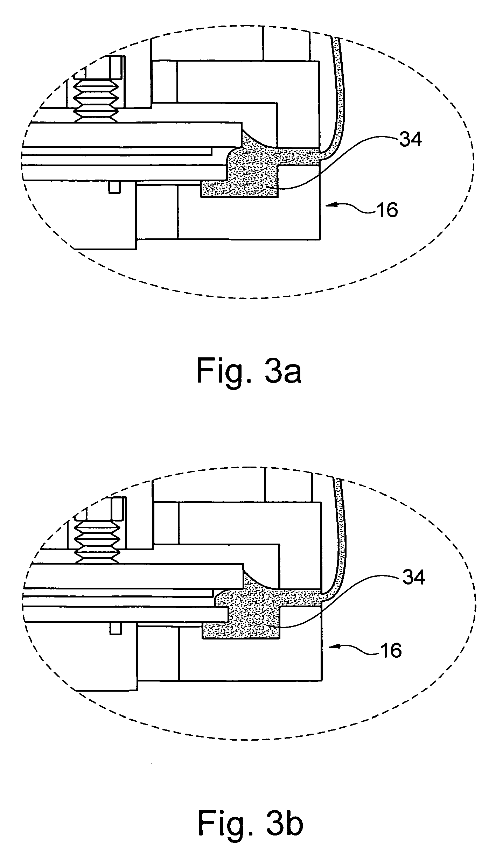

Der Fortschritt des Auflösens der Verbindungsschicht 3 im Bereich des Seitenrands 23 ist in den Figuren 3a, 3b und schließlich 3c dargestellt.

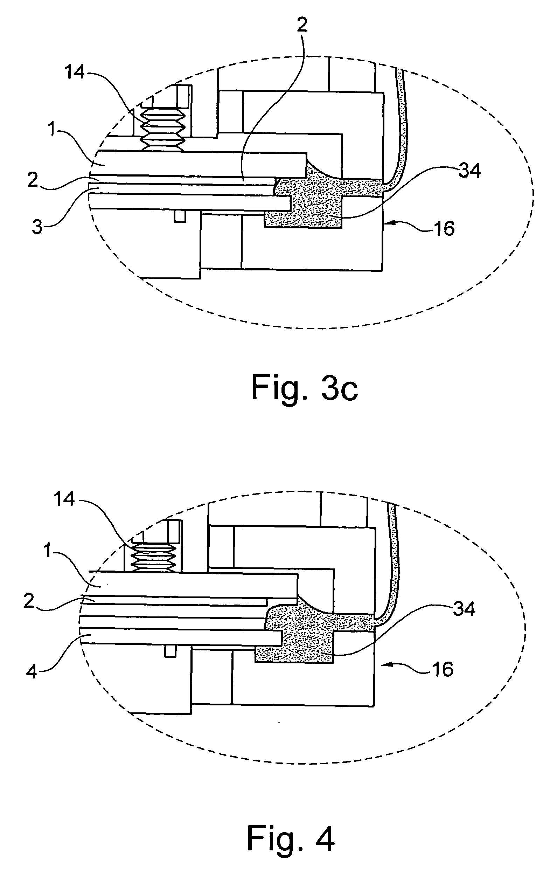

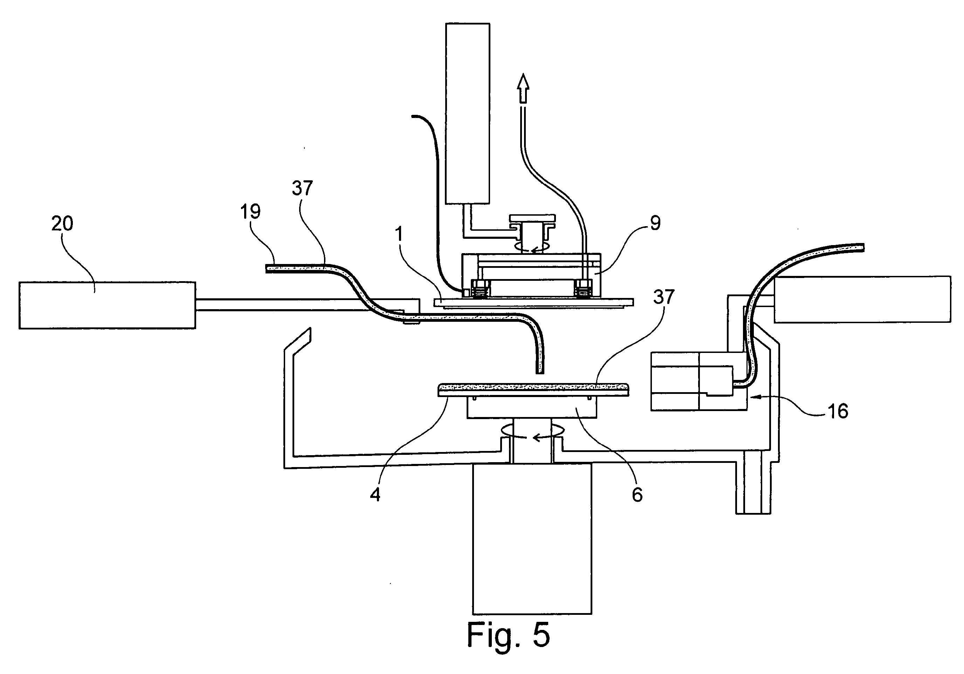

Bei Erreichen der in Figur 3c dargestellten, nahezu vollständigen Auflösung des Randbereichs der Verbindungsschicht 3 bis hin zu der haftreduzierenden Schicht 2 wird der Wafer 4 durch die als Balg ausgebildeten Saugnäpfe 14 von dem Träger 1 abgehoben, da die haftreduzierende Schicht 2 keine genügende Haftkraft im Vergleich zu der durch die Saugnäpfe 14 wirkenden Zugkraft aufbringt. Durch den die Distanz des Trägers 1 zur Waferaufnahme 9 messenden Sensor 13 wird festgestellt, dass der Träger 1 von dem Wafer 4 abgelöst ist (siehe Figur 4), so dass die Zufuhr von Lösungsmittel 34 in die Arbeitskammer 28 gestoppt werden kann und die Löseeinrichtung 16 durch den Löseeinrichtungsaktuator 20 in die Figur 5 dargestellte Ausgangsstellung bewegt werden kann.

Anschließend wird der Träger 1 durch den Waferaufnahmeaktuator 11 nach oben abgehoben, um eine Reinigung des Wafers 4 mittels der Lösungsmittelleitung 19 zu ermöglichen. Durch Rotation des Wafers 4 wird das über die Lösungsmittelleitung 19 aufgetragene Lösungsmittel 37 nach Reinigung des Wafers 4 entfernt.

Anschließend kann der Wafer 4 durch einen Roboterarm weiteren Vorrichtungen und Verfahrensschritten zugeführt werden und die erfindungsgemäße Vorrichtung kann mit einem neuen Träger-Wafer-Verbund 21 beladen werden.

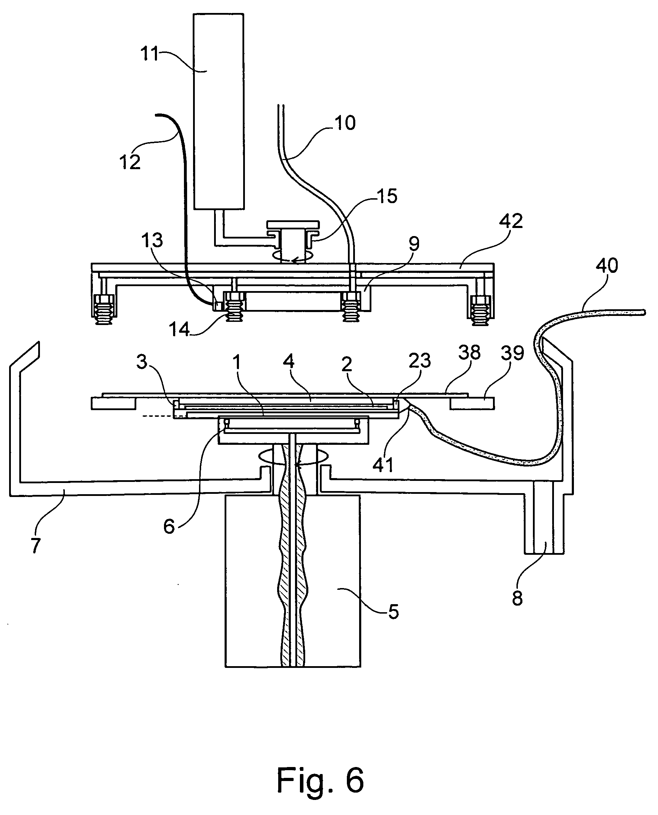

In Figur 6 ist eine alternative Ausführungsform der erfindungsgemäßen Vorrichtung gezeigt, die geeignet ist, auf einer Folie 38 aufgebrachten Träger-Wafer-Verbund 21 wie oben grundsätzlich beschrieben zu verarbeiten.

Denn die Folie 38 wird von einem Filmrahmen 39 gehalten, der den seitlichen Zugang zu dem Träger-Wafer-Verbund 21 in der oben beschriebenen Art und Weise erschwert.

Die Löseeinrichtung 16 besteht daher bei der Ausführungsform gemäß Figur 6 aus einer, insbesondere freitragenden, Lösungsmittelleitung 40 mit einem Ausgang 41, der im Bereich des Seitenrandes 23 des Träger-Wafer-Verbundes 21 angeordnet ist. Beim Verfahrensschritt des Ablösens kann die Verbindungsschicht 3 am Seitenrand 23 mit Lösungsmittel beaufschlagt werden.

Zum Ablösen des an der Folie 38 und dem Filmrahmen 39 fixierten Wafers 4 weisen die Ablösungsmittel zur Ablösung des Wafers von dem Träger zusätzlich zu der Waferaufnahme 9 eine Filmrahmenaufnahme 42 auf.

Die Filmrahmenaufnahme 42 ist zwischen der Waferaufnahme 9 und dem Waferaufnahmeaktuatorarm 30 angeordnet und mit dem an der Druckleitung 10 anliegenden Vakuum verbunden. Die Filmrahmenaufnahme 42 weist den Filmrahmen 39 ansaugbare Saugnäpfe 43 auf, die am Umfang der Filmrahmenaufnahme 42 angeordnet sind.

Die Funktion der Saugnäpfe 43 entspricht im Wesentlichen der Funktion der Saugnäpfe 14.

In einer weiteren erfindungsgemäßen Ausführungsform besteht der Träger-Wafer-Verbund 21 aus einem Zweitträger, der über eine zweite Verbindungsschicht mit dem Wafer 4 auf der dem Träger 1 gegenüberliegenden Seite analog verbunden ist. Auf diese Weise kann der Wafer 4, beispielsweise durch Vorsehen verschiedener Verbindungsmittel in den beiden Verbindungsschichten und entsprechend verschiedener Lösungsmittel auf einen anderen Träger gebracht werden beziehungsweise umgedreht werden, ohne den Wafer 4 isoliert handhaben zu müssen. Der Wafer 4 ist immer von einem Träger, entweder vom Träger 1 oder von dem Zweitträger gestützt.

### Bezugszeichenliste

- A: Aufnahmeebene
- 1: Träger
- 2: haftreduzierende Schicht
- 3: Verbindungsschicht
- 4: Wafer
- 5: Antriebsmotor
- 5w: Antriebswelle
- 6: Aufnahmeeinrichtung
- 7: Prozesskammer
- 8: Ablauf
- 9: Waferaufnahme
- 10: Durckleitung
- 11: Waferaufnahmeaktuator
- 12: Sensorleitung
- 13: Sensor
- 14: Saugnäpfe
- 15: Waferaufnahmelagerung
- 16: Löseeinrichtung
- 17: Fluidleitung
- 18: Aktuator
- 19: Lösungsmittelleitung
- 20: Lösungsmittelaktuator
- 21: Träger-Wafer-Verbund
- 22: Innenbereich
- 23: Seitenrand
- 24: Boden
- 25: Schenkel
- 26: Schenkel
- 27: Seitenwand
- 28: Arbeitskammer
- 29: Aktuatorarm
- 30: Waferaufnahmeaktuatorarm
- 31: Lösungsmittelaktuatorarm
- 32: Pfeil
- 33: Rotationspfeile
- 34: Lösungsmittel
- 35: Stirnfläche
- 36: Stirnfläche
- 37: Lösungsmittel
- 38: Folie
- 39: Filmrahmen
- 40: Lösungsmittelleitung
- 41: Ausgang
- 42: Filmrahmenaufnahme
- 43: Saugnäpfe

## Patentansprüche

1. Vorrichtung zum Ablösen eines Wafers (4) von einem mit dem Wafer (4) durch eine Verbindungsschicht (3) verbundenen Träger (1) mit
- einer Aufnahmeeinrichtung (6) zur Aufnahme eines aus dem Träger (1) und dem Wafer (4) bestehenden Träger-Wafer-Verbundes (21),
- einem Verbindungslösemittel (16, 17, 18, 29, 34) zur Lösung der durch die Verbindungsschicht (3) vorgesehenen Verbindung zwischen Träger (1) und Wafer (4) und
- Ablösungsmitteln (9, 10, 11, 14, 15, 30) zur Ablösung des Wafers (4) von dem Träger (1) oder zur Ablösung des Trägers (1) von dem Wafer (4), wobei die Ablösungsmittel rotierbar ausgebildet sind,
**dadurch gekennzeichnet,**
**dass** das Verbindungslösemittel
a) in einem Temperaturbereich von 0 bis 350°C arbeitend ausgebildet ist,
b) Fluidmittel, nämlich ein die Verbindungsschicht selektiv auflösendes Lösungsmittel (34), zur Lösung der Verbindungsschicht (3) umfasst und
c) zur teilweisen Beaufschlagung mit Fluidmittel am Umfang des Träger-Wafer-Verbundes ausgebildet ist.

2. Vorrichtung nach Anspruch 1,
**dadurch gekennzeichnet,**
**dass** das Verbindungslösemittel in einem Temperaturbereich von 10 bis 200°C, vorzugsweise von 20 bis 80°C, noch bevorzugter bei Umgebungstemperatur arbeitend ausgebildet ist.

3. Vorrichtung nach Anspruch 1,
**dadurch gekennzeichnet,**
**dass** das Verbindungslösemittel im Wesentlichen erhitzungsfrei arbeitend ausgebildet ist

4. Vorrichtung nach einem der Ansprüche 1 oder 2,
**dadurch gekennzeichnet,**
**dass** das Verbindungslösemittel mechanische Trennmittel, insbesondere eine Klinge zum Durchschneiden der Verbindungsschicht (3), zur Lösung der Verbindungsschicht (3) umfasst.

5. Vorrichtung nach einem der Ansprüche 1 oder 2,
**dadurch gekennzeichnet,**
**dass** das Verbindungslösemittel eine UV-Lichtquelle zur Lösung der Verbindungsschicht (3) umfasst.

6. Vorrichtung nach einem der vorhergehenden Ansprüche,
**dadurch gekennzeichnet,**
**dass** das Verbindungslösemittel, insbesondere ausschließlich, von einem Seitenrand (23) des Träger-Wafer-Verbundes (21) wirkend ausgebildet ist.

7. Vorrichtung nach einem der vorhergehenden Ansprüche,
**dadurch gekennzeichnet,**
**dass** eine Rotationseinrichtung (5, 5w) zur Rotation des Träger-Wafer-Verbundes (21) vorgesehen ist.

8. Vorrichtung nach einem der vorhergehenden Ansprüche,
**dadurch gekennzeichnet,**
**dass** das Verbindungslösemittel mindestens eine den Seitenrand (23) umgreifende, insbesondere an der Aufnahmeeinrichtung (6) und/oder den Ablösungsmitteln, vorzugsweise dichtend, angeschlagene, Löseeinrichtung (16) aufweist.

9. Vorrichtung nach einem der vorhergehenden Ansprüche,
**dadurch gekennzeichnet,**
**dass** die Vorrichtung eine Arbeitskammer (28) aufweist, die zur Umgebung abgedichtet ist.

10. Vorrichtung nach einem der vorhergehenden Ansprüche,
**dadurch gekennzeichnet,**
**dass** das Verbindungsmittel ein thermoplastischer Kleber ist.

11. Vorrichtung nach einem der vorhergehenden Ansprüche,
**dadurch gekennzeichnet,**
**dass** das Verbindungslösemittel Reinigungsmittel zur Reinigung des Wafers (4) umfasst.

12. Verfahren zum Ablösen eines Wafers von einem mit dem Wafer durch eine Verbindungsschicht verbundenen Träger mit folgenden Schritten:
- Aufnahme eines aus dem Träger und dem Wafer bestehenden Träger-Wafer-Verbundes auf einer Aufnahmeeinrichtung,
- Lösung der durch die Verbindungsschicht vorgesehenen Verbindung zwischen Träger und Wafer durch ein Verbindungslösemittel und
- Ablösung des Wafers von dem Träger oder zur Ablösung des Trägers von dem Wafer durch Ablösungsmittel, wobei die Ablösungsmittel rotierbar ausgebildet sind,
**dadurch gekennzeichnet,**
**dass** das Verbindungslösemittel bei der Lösung der Verbindung:
a) in einem Temperaturbereich von 0 bis 350°C arbeitet,
b) Fluidmittel, nämlich ein die Verbindungsschicht selektiv auflösendes Lösungsmittel (34), zur Lösung der Verbindungsschicht (3) umfasst und
c) zur teilweisen Beaufschlagung mit Fluidmittel am Umfang des Träger-Wafer-Verbundes ausgebildet ist.

13. Verfahren nach Anspruch 12,
**dadurch gekennzeichnet,**
**dass** die Verbindungsschicht im Bereich eines Seitenrandes des Träger-Wafer-Verbundes haftend und in einem, insbesondere aus einem Fluorpolymer gebildeten, vorzugsweise ausschließlich den Wafer kontaktierenden, Innenbereich zumindest in Richtung des Wafers weniger bis nicht haftend ausgebildet ist.

14. Verfahren nach Anspruch 12 oder 13 mit einer Vorrichtung nach einem der Ansprüche 1 bis 12.

## Claims

1. Device for stripping a wafer (4) from a carrier (1) that is connected to the wafer (4) by an interconnect layer (3) with:
- a receiving means (6) for receiving a carrier-wafer combination (21) consisting of the carrier (1) and the wafer (4),
- a connection release means (16, 17, 18, 29, 34) for releasing the connection provided by the interconnect layer (3) between the carrier (1) and the wafer (4), and
- stripping means (9, 10, 11, 14, 15, 30) for stripping the wafer (4) from the carrier (1), or for stripping the carrier (1) from the wafer (4), wherein the stripping means can be rotated,
**characterized in that**
the connection release means
a) is made to work in a temperature range from 0 to 350°C,
b) comprises fluid means for dissolving the interconnect layer (3), namely a solvent (34) that selectively dissolves the interconnect layer and
c) are designed for partial action on the periphery of the carrier-wafer combination with fluid means.

2. Device according to claims 1, wherein the connection release means is made to work in a temperature range from 10 to 200°C, preferably from 20 to 80°C, and more preferably at ambient temperature.

3. Device according to claim 1, wherein the connection release means is made to work essentially without heating.

4. Device according to one of claims 1 or 2, wherein the connection release means comprises mechanical separating means, especially a blade for cutting through the interconnect layer (3), for detaching the interconnect layer (3).

5. Device according to one of claims 1 or 2, wherein the connection release means comprises a UV light source for detaching the interconnect layer (3).

6. Device according to one of the preceding claims, wherein the connection release means is made to act especially exclusively from one side edge (23) of the carrier-wafer combination (21).

7. Device according to one of the preceding claims, wherein there is a rotation means (5, 5w) for rotation of the carrier-wafer combination (21).

8. Device according to one of the preceding claims, wherein the connection release means has at least one release device (16) that encompasses the side edge (23), especially that has struck the receiving means (6) and/or the stripping means, preferably forming a seal.

9. Device according to one of the preceding claims, wherein the device has a working chamber (28) that is sealed to the vicinity.

10. Device according to one of the preceding claims, wherein the bonding means is a thermoplastic adhesive.

11. Device according to one of the preceding claims, wherein the connection release means has detergents for cleaning the wafer (4).

12. Method for stripping a wafer from a carrier that is connected to the wafer by an interconnect layer with the following steps:
- accommodating a carrier-wafer combination consisting of the carrier and the wafer on a receiving means,
- unfixing the connection provided by the interconnect layer between the carrier and the wafer by a connection release means, and
- stripping the wafer from the carrier, or for stripping the carrier from the wafer by stripping means, wherein the stripping means can be rotated,
**characterized in that**
the connection release means during dissolving of the interconnect layer
a) works in a temperature range from 0 to 350°C,
b) comprises fluid means for dissolving the interconnect layer (3), namely a solvent (34) that selectively dissolves the interconnect layer and
c) are designed for partial action on the periphery of the carrier-wafer combination with fluid means.

13. Method according to claim 12, wherein the interconnect layer in the region of one side edge of the carrier-wafer combination is made adhesive and in one inner region, formed especially from a fluoropolymer, preferably making contact solely with the wafer, is made less adhesive to nonadhesive at least in the direction of the wafer.

14. Method according to claim 12 or 13 with a device according to one of claims 1 to 12.

## Revendications

1. Dispositif pour détacher une tranche (4) d'un support (1) relié à la tranche (4) par une couche de liaison (3) comprenant
- un dispositif de réception (6) pour recevoir un composite support-tranche (21) composé du support (1) et de la tranche (4),
- un moyen de détachement de liaison (16, 17, 18, 29, 34) pour séparer la liaison entre le support (1) et la tranche (4) fournie par la couche de liaison (3) et
- des moyens d'enlèvement (9, 10, 11, 14, 15, 30) pour enlever la tranche (4) du support (1) ou pour enlever le support (1) de la tranche (4), sachant que les moyens d'enlèvement sont conçus rotatifs,
**caractérisé en ce que**
le moyen de détachement de liaison
a) est conçu pour fonctionner dans une plage de température de 0° à 350°C,
b) comprend des moyens fluidiques, à savoir un solvant (34) dissolvant la couche de liaison de façon sélective pour détacher la couche de liaison (3) et
c) est conçu pour appliquer partiellement du moyen fluidique sur le pourtour du composite support-tranche.

2. Dispositif selon la revendication 1, **caractérisé en ce que** le moyen de détachement de liaison est conçu pour fonctionner dans une plage de température de 10° à 200°C, de préférence de 20 à 80°C, plus encore de préférence à température ambiante.

3. Dispositif selon la revendication 1, **caractérisé en ce que** le moyen de détachement de liaison est conçu pour fonctionner essentiellement sans chauffe.

4. Dispositif selon la revendication 1 ou 2, **caractérisé en ce que** le moyen de détachement de liaison comprend des moyens de séparation mécaniques, en particulier une lame pour trancher la couche de liaison (3), pour détacher la couche de liaison (3).

5. Dispositif selon la revendication 1 ou 2, **caractérisé en ce que** le moyen de détachement de liaison comprend une source de lumière UV pour détacher la couche de liaison (3).

6. Dispositif selon l'une des revendications précédentes, **caractérisé en ce que** le moyen de détachement de liaison est conçu pour agir, en particulier exclusivement, depuis un bord (23) du composite support-tranche (21).

7. Dispositif selon l'une des revendications précédentes, **caractérisé en ce qu'**un dispositif de rotation (5, 5w) est prévu pour la rotation du composite support-tranche (21).

8. Dispositif selon l'une des revendications précédentes, **caractérisé en ce que** le moyen de détachement de liaison présente au moins un dispositif de détachement (16) entourant le bord (23), placé, de préférence en étanchéité, sur le dispositif de réception (6) et/ou les moyens d'enlèvement.

9. Dispositif selon l'une des revendications précédentes, **caractérisé en ce que** le dispositif présente une chambre de travail (28) qui est étanche contre l'environnement.

10. Dispositif selon l'une des revendications précédentes, **caractérisé en ce que** le moyen de liaison est une colle thermoplastique.

11. Dispositif selon l'une des revendications précédentes, **caractérisé en ce que** le moyen de détachement de liaison comprend des moyens de nettoyage pour nettoyer la tranche (4).

12. Procédé pour détacher une tranche d'un support relié à la tranche par une couche de liaison, comprenant les étapes suivantes
- réception d'un composite support-tranche composé du support et de la tranche sur un dispositif de réception,
- détachement de la liaison entre le support et la tranche fournie par la couche de liaison par un moyen de détachement de liaison et
- enlèvement de la tranche du support ou enlèvement du support de la tranche par des moyens d'enlèvement, sachant que les moyens d'enlèvement sont conçus rotatifs,
**caractérisé en ce que**
le moyen de détachement de liaison, lors du détachement de la liaison :
a) fonctionne dans une plage de température de 0° à 350°C,
b) comprend des moyens fluidiques, à savoir un solvant (34) dissolvant la couche de liaison de façon sélective pour détacher la couche de liaison (3) et
c) est conçu pour appliquer partiellement du moyen fluidique sur le pourtour du composite support-tranche.

13. Procédé selon la revendication 12, **caractérisé en ce que** la couche de liaison est conçue en étant adhérente au niveau d'un bord du composite support-tranche et moins adhérente à non-adhérente au moins en direction de la tranche, dans une zone intérieure, formée en particulier dans un fluoropolymère, de préférence exclusivement en contact avec la tranche.

14. Procédé selon la revendication 12 ou 13 comprenant un dispositif selon l'une des revendications 1 à 12.
